# EUROPEAN PATENT SPECIFICATION

(11) **EP 4 525 418 B1**
(45) Date of publication and mention of the grant of the patent: **28.10.2026**
(21) Application number: 23802734.6
(22) Date of filing: 04.05.2023
(51) Int. Cl.: H04M 1/03, H04M 1/18, H04M 1/02, H05K 5/02

(54) **ELECTRONIC DEVICE**
ELEKTRONISCHE VORRICHTUNG
DISPOSITIF ÉLECTRONIQUE

(30) Priority: 07.05.2022 CN 202210491715
(43) Date of publication of application: 19.03.2025
(73) Proprietor: Vivo Mobile Communication Co., Ltd., Dongguan, Guangdong 523863 (CN)
(72) Inventor: LIU, Peng, Dongguan, Guangdong 523863 (CN); PAN, Baoyou, Dongguan, Guangdong 523863 (CN)
(74) Representative: Lavoix
(86) International application number: PCT/CN2023/092032
(87) International publication number: WO 2023/216962

(56) References cited:
- WO-A1-2021/189867
- CN-A- 107 911 783
- CN-A- 114 745 461
- CN-U- 206 294 215
- CN-U- 209 627 421
- CN-U- 211 183 949
- US-A1- 2019 025 133
- US-A1- 2021 148 875

## Description

### TECHNICAL FIELD

This application relates to the field of electronic product technologies, and specifically, to an electronic device.

### BACKGROUND

An existing electronic device usually includes a large quantity of electric components. Because some electric components need to be communicated with an external environment, a housing of the electronic device needs to be provided with a corresponding breather hole, so that the electric components are communicated with the external environment through the breather hole. However, when there are many electric components needing to be communicated with the external environment in the electronic device, a large quantity of breather holes need to be provided on the housing of the electronic device. Consequently, overall waterproof performance and beauty of the electronic device deteriorate.

US2021/148875A1 relates to an electronic device having a structure equipped with a gas sensor for analyzing the composition of an outside air.

US2019/025133A1 relates to electronic devices having environmental sensors.

### SUMMARY

This application provides an electronic device to improve overall waterproof performance and beauty of the electronic device. The invention is set out in the appended set of claims.

In embodiments of this application, the barometer and the first acoustic module share the first opening, so that a ventilation requirement of two components can be met by providing only one opening on the housing. In this way, a quantity of openings on the housing in the electronic device can be reduced, thereby improving overall waterproof performance and beauty of the electronic device.

### BRIEF DESCRIPTION OF THE DRAWINGS

FIG. 1 is a first diagram of an inner structure of an electronic device according to an embodiment of this application;
FIG. 2 is a second diagram of an inner structure of an electronic device according to an embodiment of this application;
FIG. 3 is a third diagram of an inner structure of an electronic device according to an embodiment of this application;
FIG. 4 is a fourth diagram of an inner structure of an electronic device according to an embodiment of this application; and
FIG. 5 is a fifth diagram of an inner structure of an electronic device according to an embodiment of this application.

### DESCRIPTION OF EMBODIMENTS

The following clearly describes technical solutions in embodiments of this application with reference to the accompanying drawings in the embodiments of this application. Obviously, the described embodiments are a part rather than all of embodiments of this application. All other embodiments obtained by a person of ordinary skill in the art based on the embodiments of this application shall fall within the protection scope of this application. The present invention is defined by the attached independent claims. Advantageous embodiments are described in the attached dependent claims. Embodiments and/or examples mentioned in the description that do not fall under the scope of the claims are useful for understanding the present invention.

In the specification and claims of this application, the terms such as "first" and "second" are used to distinguish between similar objects but do not indicate a particular order or sequence. It is to be understood that the terms used in such ways are interchangeable under appropriate circumstances, so that the embodiments of this application can be implemented in sequences other than those illustrated or described herein. In addition, the objects distinguished by "first, "second", and the like are usually of the same type, and a quantity of objects is not limited. For example, there may be one or a plurality of first objects. In addition, "and/or" used in this specification and the claims indicates at least one of the connected objects. The character "/" generally indicates an "or" relationship between associated objects.

With reference the accompanying drawings, the electronic device provided in the embodiments of this application is described in detail below by using specific embodiments and application scenarios thereof.

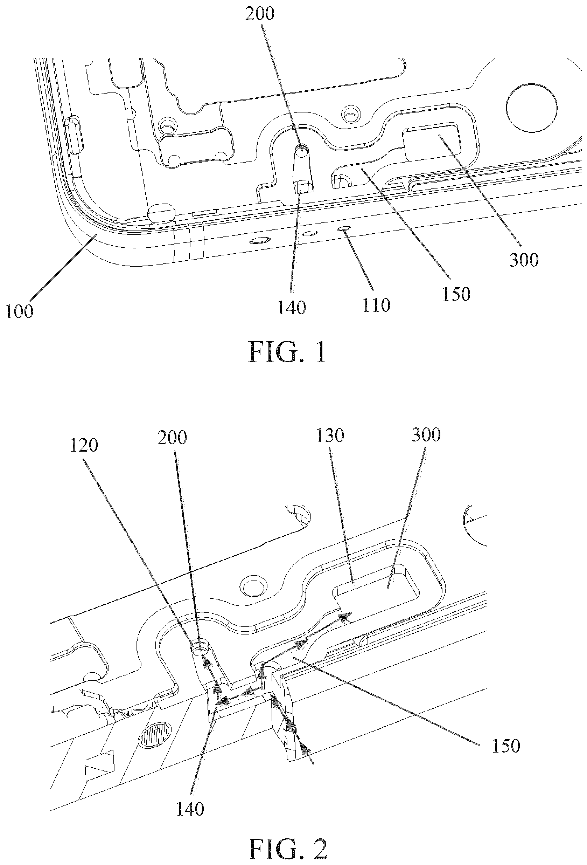

FIG. 1 to FIG. 5 are diagrams of inner structures of an electronic device according to an embodiment of this application. The electronic device includes:
a housing 100, where the housing 100 is provided with a first opening 110, and the housing 100 is internally provided with a first channel 140 and a second channel 150;
a first acoustic module 200, where the first acoustic module 200 is disposed in the housing 100, the first channel 140 communicates the first acoustic module 200 with the first opening 110; and
a barometer 300, where the barometer 300 is disposed in the housing 100, and the second channel 150 communicates the barometer 300 with the first opening 110.

It can be understood that the first acoustic module 200 may be any acoustic module that needs to be communicated with an external environment in the electronic device, for example, may be an acoustic module such as a microphone, a speaker, or a telephone receiver. Correspondingly, the first opening 110 may be an opening such as a sound outlet hole or a sound slot.

Specifically, because the first channel 140 communicates the first acoustic module 200 with the first opening 110, the first acoustic module 200 can be communicated with the external environment.

Correspondingly, because the second channel 150 communicates the barometer 300 with the first opening 110, atmospheric pressure at the barometer 300 is basically the same as atmospheric pressure outside the electronic device. In this way, an atmospheric pressure value detected by the barometer 300 installed in the housing 100 may be viewed as the environment atmospheric pressure outside the electronic device. Further, a current altitude of the electronic device can be determined based on the atmospheric pressure value, and the atmospheric pressure value and the altitude can be output by using a display screen of the electronic device.

In an embodiment of this application, the housing 100 may include a first installation position 120 configured to install the first acoustic module 200. The first installation position 120 may include a first air intake vent chamber. The first channel 140 may communicate the first air intake vent chamber with the first opening 110, and a ventilation end of the first acoustic module 200 is located in the first air intake vent chamber to communicate the first acoustic module 200 with the external environment. Correspondingly, the housing 100 may include a second installation position 130 configured to install the barometer 300. The second installation position 130 may include a second air intake vent chamber. The second channel 150 may communicate the second air intake vent chamber with the first opening 110, and a detection end of the barometer 300 is located in the second air intake vent chamber to communicate the barometer 300 with the external environment.

It can be understood that the first channel 140 and the second channel 150 may be two channels independent of each other. In this way, interference with atmospheric pressure of air in the second channel 150 can be prevented when there is a vibration signal in the first channel 140, thereby improving accuracy of a detection result output by the barometer 300.

The first opening 110 is provided on an outer surface of the housing 100. The first installation position 120, the second installation position 130, the first channel 140, and the second channel 150 may be provided on an installation bracket in the housing 100, for example, may be provided on a mainboard cover of the electronic device.

Refer to FIG. 2. The direction indicated by arrows in FIG. 2 is: Outside air flows from the first opening 110 through the first channel 140 and the second channel 150 separately to the first acoustic module 200 and the barometer 300.

In this implementation, the barometer 300 and the first acoustic module 200 share the first opening 110, so that a ventilation requirement of two components can be met by providing only one opening on the housing 100. In this way, a quantity of openings on the housing 100 in the electronic device can be reduced, thereby improving overall waterproof performance and beauty of the electronic device.

Optionally, the first channel 140 comprises a first ventilation chamber 141 and a first sub channel 142, the first sub channel 142 communicates the first acoustic module 200 with the first ventilation chamber 141, and the first opening 110 is communicated with the first ventilation chamber 141.

The second channel 150 is communicated with the first ventilation chamber 141 to communicate the barometer 300 with the first opening 110.

The first opening 110 is a through hole extending from an outer wall of the housing 100 to an inner wall of the first ventilation chamber 141.

Refer to FIG. 2. After the outside air enters the first ventilation chamber 141 from the first opening 110, the air entering the first ventilation chamber 141 may be divided into two branches which separately flow into the first sub channel 142 and the second channel 150. Correspondingly, a sound signal output by the first acoustic module 200 may sequentially passes through the first sub channel 142, the first ventilation chamber 141, and the first opening 110, and is delivered to the outside of the electronic device.

In this implementation, the first channel 140 includes the first ventilation chamber 141 and the first sub channel 142, and the first sub channel 142, the second channel 150, and the first opening 110 are separately communicated with the first ventilation chamber 141. In this way, the first acoustic module 200 and the barometer 300 can be separately communicated with the outside by providing only one opening. In addition, because the air entering the first ventilation chamber 141 can be divided into two branches which separately flow into the first sub channel 142 and the second channel 150, the air entering the first sub channel 142 is relatively isolated from the air entering the second channel 150, thereby preventing the first acoustic module 200 from interfering with a detection process of the barometer 300.

Optionally, the second channel 150 includes a second ventilation chamber 151 and a second sub channel 152, and the barometer 300 is communicated with the second ventilation chamber 151 through the second sub channel 152.

The housing 100 is internally provided with a first partition board 160 located between the first ventilation chamber 141 and the second ventilation chamber 151, the first partition board 160 is provided with a breather hole, and the first ventilation chamber 141 is communicated with the second ventilation chamber 151 through the breather hole.

In this implementation, the first ventilation chamber 141 is isolated from the second ventilation chamber 151 by using the partition board, and the breather hole is provided on the partition board. In this way, the first acoustic module 200 and the barometer 300 can be separately communicated with the outside by providing only one opening. In addition, an isolation effect between the first sub channel 142 and the second sub channel 152 can further be improved.

Optionally, the first ventilation chamber 141 is a strip-shaped chamber extending along a first direction, the first sub channel 142 is a strip-shaped channel located in a first plane, and the first direction is set in an angle to the first plane.

The first ventilation chamber 141 includes a first open end and a first closed end, the first open end is opposite to the first closed end, the first ventilation chamber 141 is communicated with a first end of the first sub channel 142 through the first open end, and a second end of the first sub channel 142 is oriented towards the first acoustic module 200.

A distance between the breather hole and the first closed end is less than a distance between the breather hole and the first open end.

In this implementation, to make the distance between the breather hole and the second closed end less than the distance between the breather hole and the first open end, the distance between the breather hole and the first open end can be increased. The breather hole and the first open end are respectively air intake vents of the second channel 150 and the first sub channel 142. Therefore, by increasing the distance between the breather hole and the first open end, isolation between the second channel 150 and the first sub channel 142 can further be improved.

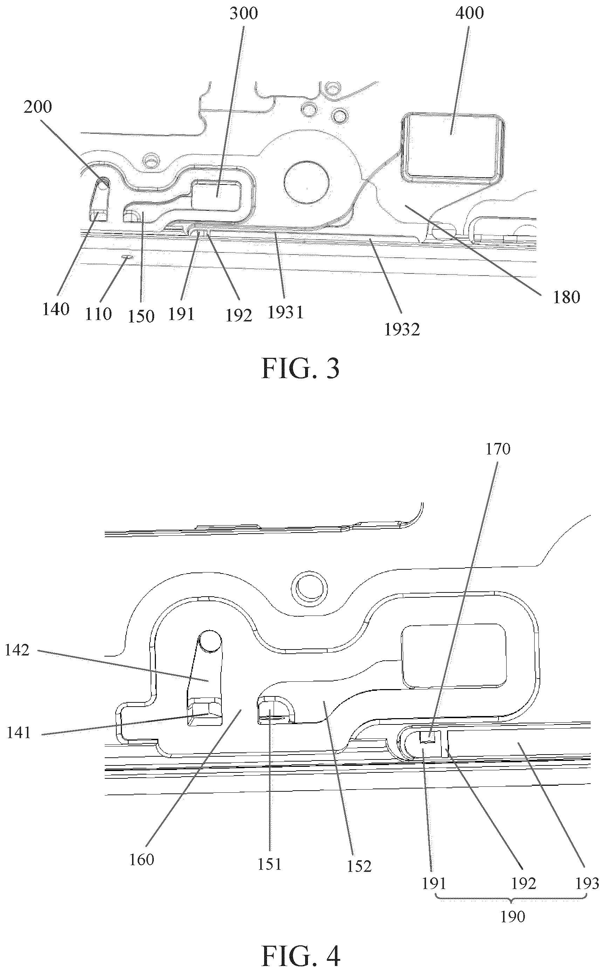

Refer to FIG. 4. The second ventilation chamber 151 is a strip-shaped chamber extending along the first direction, and the second sub channel 152 is a strip-shaped channel located in the first plane.

The second ventilation chamber 151 includes a second open end and a second closed end, the second open end is opposite to the second closed end, the second ventilation chamber 151 is communicated with a first end of the second sub channel 152 through the second open end, and a second end of the second sub channel 152 is oriented towards the barometer 300.

A distance between the breather hole and the second closed end is less than a distance between the breather hole and the second open end.

In addition, the first direction may be in any angle to the first plane. In an embodiment of this application, the first direction is perpendicular to the first plane.

In this implementation, the first direction is set perpendicular to the first plane, so that when signals transmitted in the second channel 150 include a vibration signal, and when the vibration signal flows through a joint of the second ventilation chamber 151 and the second sub channel 152, the vibration signal has a significant attenuation because of blocking of the inner wall of the second sub channel 152, thereby further improving accuracy of a detection result of the barometer 300.

Optionally, the electronic device further includes a second acoustic module 400, the second acoustic module 400 is disposed in the housing 100, the housing 100 is further provided with a fourth channel 180, and the fourth channel 180 communicates the second acoustic module 400 with the second opening 190.

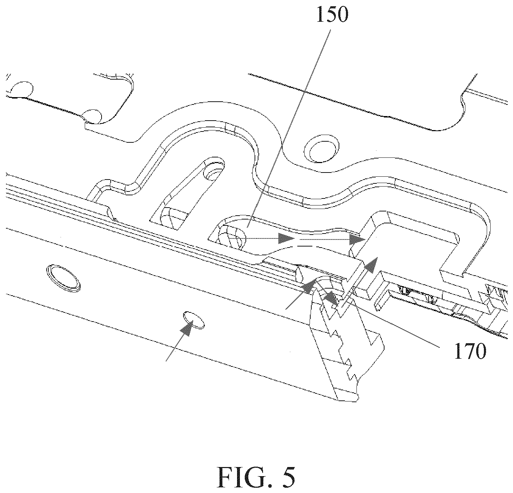

Refer to FIG. 5. The direction indicated by arrows in FIG. 5 is: Outside air flows from the first opening 110 through the second channel 150 to the barometer 300, and outside air flows from the second opening 190 through the third channel 170 to the barometer 300.

In this implementation, the barometer 300 and the first acoustic module 200 share the first opening 110. Moreover, the barometer 300 is communicated with the second opening 190 through the third channel 170. In this way, the barometer 300 may be communicated with the outside separately through the first opening 110 and the second opening 190, thereby further ensuring good ventilation performance of the barometer 300, and helping improve the accuracy of the detection result of the barometer 300.

Optionally, the electronic device further includes a second acoustic module 400, the second acoustic module 400 is disposed in the housing 100, the housing 100 is further provided with a fourth channel 180, and the fourth channel 180 communicates the second acoustic module 400 with the second opening 190.

It can be understood that the second acoustic module 400 and the first acoustic module 200 are different acoustic modules in the electronic device, and the second acoustic module 400 may be any acoustic module that needs to be communicated with the external environment in the electronic device, for example, may be an acoustic module such as a microphone, a speaker, or a telephone receiver. Correspondingly, the second opening 190 may be an opening such as a sound outlet hole or a sound slot.

In this implementation, the barometer 300 and the first acoustic module 200 share the first opening 110. Moreover, the barometer 300 and the second acoustic module 400 share the second opening 190. In this way, the barometer 300 may be communicated with the outside separately through the first opening 110 and the second opening 190, thereby further ensuring good ventilation performance of the barometer 300, and helping improve the accuracy of the detection result of the barometer 300.

Optionally, the second opening 190 is a strip-shaped gap formed in the housing 100, a second partition board 192 is disposed in the strip-shaped gap, the second partition board 192 divides the strip-shaped gap into a first sub gap 191 and a second sub gap 193, the third channel 170 communicates the barometer 300 with the first sub gap 191, and the fourth channel 180 communicates the third installation position with the second sub gap 193.

It can be understood that because of blocking of the second partition board 192, the third channel 170 is not communicated with the second sub gap 193, and the fourth channel 180 is not communicated with the first sub gap 191. The strip-shaped gap may be a sound slot of the electronic device.

In this implementation, by disposing the second partition board 192, the strip-shaped gap is divided into the first sub gap 191 and the second sub gap 193, the third channel 170 communicates the barometer 300 with the first sub gap 191, and the fourth channel 180 communicates the third installation position with the second sub gap 193. In this way, the barometer 300 and the second acoustic module 400 can share the strip-shaped gap. Moreover, the third channel 170 can be relatively isolated from the fourth channel 180, preventing a signal transmitted in the fourth channel 180 from affecting atmospheric pressure in the third channel 170, and helping improve the accuracy of the detection result of the barometer 300.

Optionally, an opening area of the first sub gap 191 is less than an opening area of the second sub gap 193.

In this implementation, by making the opening area of the first sub gap 191 less than the opening area of the second sub gap 193, a ventilation volume of the barometer 300 can be increased. Moreover, a problem, caused by an excessively small opening area of the second sub gap 193, of an insufficient ventilation volume of the second acoustic module 400 can be avoided.

Optionally, the strip-shaped gap comprises a first segment, a second segment 1931, and a third segment 1932, the second segment 1931 is located between the first segment and the third segment 1932, the first segment forms the first sub gap 191, the second segment 1931 and the third segment 1932 form the second sub gap 193, and the fourth channel 180 communicates the third installation position with the third segment 1932.

In this implementation, the third channel 170 is communicated with the first segment, and the fourth channel 180 is communicated with the third segment 1932. Because the second segment 1931 is located between the first segment and the third segment 1932, a distance between an air intake vent of the third channel 170 and an air intake vent of the fourth channel 180 can be increased effectively, thereby further improving the isolation between the third channel 170 and the fourth channel 180.

It should be noted that in this specification, the term "comprise", "include", or any other variants thereof are intended to encompass in a non-exclusive mode, so that a process, a method, an object, or an apparatus including a series of elements not only includes those elements, but also includes other elements that are not explicitly listed, or elements that are inherent to such a process, a method, an object, or an apparatus. An element defined by the phrase "including a ..." does not exclude the presence of the same element in the process, method, object, or apparatus including the element, without more restrictions. In addition, it should be noted that the scopes of the methods and apparatus in the embodiments of this application are not limited to performing functions in the shown or discussed order, but may also include performing functions in a substantially simultaneous manner or in a reverse order depending on involved functions. For example, the described methods may be performed in an order different from that described, and various steps may be added, omitted, or combined. Furthermore, features described with reference to some examples may be combined in other examples.

The embodiments of this application are described above with reference to the accompanying drawings. However, this application is not limited to the foregoing specific implementations. The foregoing specific implementations are only illustrative and not restrictive. Inspired by this application, a person of ordinary skill in the art can further make many forms without departing from the purpose of this application and the scope protected by the claims, all of which fall within the protection scope of this application.

## Claims

1. An electronic device, comprising:
a housing (100), wherein the housing (100) is provided with a first opening (110), and the housing (100) is internally provided with a first channel (140) and a second channel (150);
a first acoustic module (200), wherein the first acoustic module (200) is disposed in the housing (100), the first channel communicates the first acoustic module (200) with the first opening (110); and
a barometer (300), wherein the barometer (300) is disposed in the housing (100), and the second channel (150) communicates the barometer (300) with the first opening (110);
wherein the first channel (140) comprises a first ventilation chamber (141) and a first sub channel (142), the first sub channel (142) is arranged between the first acoustic module (200) and the first ventilation chamber (141), and communicates the first acoustic module (200) with the first ventilation chamber (141), and the first opening (110) is communicated with the first ventilation chamber (141); and
the second channel (150) is communicated with the first ventilation chamber (141) to communicate the barometer (300) with the first opening (110);
the first ventilation chamber (141) is a strip-shaped chamber extending along a first direction, the first sub channel (142) is a strip-shaped channel located in a first plane, and the first direction is set in an angle to the first plane;
the first channel (140) and the second channel (150) are independent of each other.

2. The electronic device according to claim 1, wherein the second channel (150) comprises a second ventilation chamber (151) and a second sub channel (152), and the barometer (300) is communicated with the second ventilation chamber (151) through the second sub channel (152); and
the housing (100) is internally provided with a first partition board (160) located between the first ventilation chamber (141) and the second ventilation chamber (151), the first partition board (160) is provided with a breather hole, and the first ventilation chamber (141) is communicated with the second ventilation chamber (151) through the breather hole.

3. The electronic device according to claim 2, wherein
the first ventilation chamber (141) comprises a first open end and a first closed end, the first open end is opposite to the first closed end, the first ventilation chamber (141) is communicated with a first end of the first sub channel (142) through the first open end, and a second end of the first sub channel (142) is oriented towards the first acoustic module (200); and
a distance between the breather hole and the first closed end is less than a distance between the breather hole and the first open end.

4. The electronic device according to claim 1, wherein the first opening (110) is a through hole extending from an outer wall of the housing (100) to an inner wall of the first ventilation chamber (141).

5. The electronic device according to claim 1, wherein the housing (100) is further provided with a second opening (190), the housing (100) is further provided with a third channel (170), and the third channel (170) communicates the barometer (300) with the second opening (190).

6. The electronic device according to claim 5, wherein the electronic device further comprises a second acoustic module (400), the second acoustic module (400) is disposed in the housing (100), the housing (100) is further provided with a fourth channel (180), and the fourth channel (180) communicates the second acoustic module (400) with the second opening (190).

7. The electronic device according to claim 6, wherein the second opening (190) is a strip-shaped gap formed in the housing (100), a second partition board (192) is disposed in the strip-shaped gap, the second partition board (192) divides the strip-shaped gap into a first sub gap (191) and a second sub gap (193), the third channel (170) communicates the barometer (300) with the first sub gap (191), and the fourth channel (180) communicates the second acoustic module (400) with the second sub gap (193).

8. The electronic device according to claim 7, wherein an opening area of the first sub gap (191) is less than an opening area of the second sub gap (193).

9. The electronic device according to claim 7, wherein the strip-shaped gap comprises a first segment, a second segment (1931), and a third segment (1932), the second segment (1931) is located between the first segment and the third segment (1932), the first segment forms the first sub gap (191), the second segment (1931) and the third segment (1932) form the second sub gap (193), and the fourth channel (180) communicates the second acoustic module with the third segment (1932).

## Patentansprüche

1. Eine elektronische Vorrichtung, umfassend:
ein Gehäuse (100), wobei das Gehäuse (100) mit einer ersten Öffnung (110) versehen ist, und das Gehäuse (100) im Inneren mit einem ersten Kanal (140) und einem zweiten Kanal (150) versehen ist;
ein erstes akustisches Modul (200), wobei das erste akustische Modul (200) in dem Gehäuse (100) angeordnet ist, wobei der erste Kanal das erste akustische Modul (200) mit der ersten Öffnung (110) in Verbindung bringt; und
ein Barometer (300), wobei das Barometer (300) in dem Gehäuse (100) angeordnet ist und der zweite Kanal (150) das Barometer (300) mit der ersten Öffnung (110) in Verbindung bringt;
wobei der erste Kanal (140) eine erste Belüftungskammer (141) und einen ersten Unterkanal (142) umfasst, wobei der erste Unterkanal (142) zwischen dem ersten akustischen Modul (200) und der ersten Belüftungskammer (141) angeordnet ist und das erste akustische Modul (200) mit der ersten Belüftungskammer (141) in Verbindung bringt, und die erste Öffnung (110) mit der ersten Belüftungskammer (141) in Verbindung steht; und
der zweite Kanal (150) mit der ersten Belüftungskammer (141) in Verbindung steht, um das Barometer (300) mit der ersten Öffnung (110) in Verbindung zu bringen;
die erste Belüftungskammer (141) eine streifenförmige Kammer ist, die sich entlang einer ersten Richtung erstreckt, wobei der erste Unterkanal (142) ein streifenförmiger Kanal ist, der in einer ersten Ebene angeordnet ist, und die
erste Richtung in einem Winkel zu der ersten Ebene eingestellt ist;
der erste Kanal (140) und der zweite Kanal (150) voneinander unabhängig sind.

2. Die elektronische Vorrichtung nach Anspruch 1, wobei der zweite Kanal (150) eine zweite Belüftungskammer (151) und einen zweiten Unterkanal (152) umfasst und das Barometer (300) mit der zweiten Belüftungskammer (151) durch den zweiten Unterkanal (152) in Verbindung steht; und
das Gehäuse (100) im Inneren mit einer ersten Trennplatte (160) versehen ist, die zwischen der ersten Belüftungskammer (141) und der zweiten Belüftungskammer (151) angeordnet ist, wobei die erste Trennplatte (160) mit einer Entlüftungsöffnung versehen ist und die erste Belüftungskammer (141) mit der zweiten Belüftungskammer (151) durch die Entlüftungsöffnung in Verbindung steht.

3. Die elektronische Vorrichtung nach Anspruch 2, wobei
die erste Belüftungskammer (141) ein erstes offenes Ende und ein erstes geschlossenes Ende umfasst, wobei das erste offene Ende dem ersten geschlossenen Ende gegenüberliegt, wobei die erste Belüftungskammer (141) mit einem ersten Ende des ersten Unterkanals (142) durch das erste offene Ende in Verbindung steht und ein das zweite Ende des ersten Teilkanals (142) ist zu dem ersten akustischen Modul (200) hin ausgerichtet;
und
ein Abstand zwischen der Entlüftungsöffnung und dem ersten geschlossenen Ende ist kleiner als ein Abstand zwischen der Entlüftungsöffnung und dem ersten offenen Ende.

4. Elektronische Vorrichtung nach Anspruch 1, wobei die erste Öffnung (110) ein Durchgangsloch ist, das sich von einer Außenwand des Gehäuses (100) zu einer Innenwand der ersten Belüftungskammer (141) erstreckt.

5. Elektronische Vorrichtung nach Anspruch 1, wobei das Gehäuse (100) ferner mit einer zweiten Öffnung (190) versehen ist, das Gehäuse (100) ferner mit einem dritten Kanal (170) versehen ist und der dritte Kanal (170) das Barometer (300) mit der zweiten Öffnung (190) verbindet.

6. Elektronische Vorrichtung nach Anspruch 5, wobei die elektronische Vorrichtung ferner ein zweites akustisches Modul (400) umfasst, wobei das zweite akustische Modul (400) in dem Gehäuse (100) angeordnet ist, das Gehäuse (100) ferner mit einem vierten Kanal (180) versehen ist und der vierte Kanal (180) das zweite akustische Modul (400) mit der zweiten Öffnung (190) verbindet.

7. Elektronische Vorrichtung nach Anspruch 6, wobei die zweite Öffnung (190) ein streifenförmiger Spalt ist, der in dem Gehäuse (100) ausgebildet ist, wobei eine zweite Trennplatte (192) in dem streifenförmigen Spalt angeordnet ist, wobei die zweite Trennplatte (192) den streifenförmigen Spalt in einen ersten Teilspalt (191) und einen zweiten Teilspalt (193) unterteilt, wobei der dritte Kanal (170) das Barometer (300) mit dem ersten Teilspalt (191) verbindet und der vierte Kanal (180) das zweite akustische Modul (400) mit dem zweiten Teilspalt (193) verbindet.

8. Elektronische Vorrichtung nach Anspruch 7, wobei eine Öffnungsfläche des ersten Teilspalts (191) kleiner ist als eine Öffnungsfläche des zweiten Teilspalts (193).

9. Elektronische Vorrichtung nach Anspruch 7, wobei der streifenförmige Spalt ein erstes Segment, ein zweites Segment (1931) und ein drittes Segment (1932) umfasst, wobei sich das zweite Segment (1931) zwischen dem ersten Segment und dem dritten Segment (1932) befindet, wobei das erste Segment den ersten Teilspalt (191) bildet, wobei das zweite Segment (1931) und das dritte Segment (1932) den zweiten Teilspalt (193) bilden und der vierte Kanal (180) das zweite akustische Modul mit dem dritten Segment (1932) verbindet.

## Revendications

1. Dispositif électronique, comprenant :
un boîtier (100), dans lequel le boîtier (100) est pourvu d'une première ouverture (110), et le boîtier (100) est pourvu intérieurement d'un premier canal (140) et d'un deuxième canal (150) ;
un premier module acoustique (200), dans lequel le premier module acoustique (200) est disposé dans le boîtier (100), le premier canal mettant en communication le premier module acoustique (200) avec la première ouverture (110) ; et
un baromètre (300), dans lequel le baromètre (300) est disposé dans le boîtier (100), et le deuxième canal (150) met en communication le baromètre (300) avec la première ouverture (110) ;
dans lequel le premier canal (140) comprend une première chambre de ventilation (141) et un premier sous-canal (142), le premier sous-canal (142) étant agencé entre le premier module acoustique (200) et la première chambre de ventilation (141), et mettant en communication le premier module acoustique (200) avec la première chambre de ventilation (141), et la première ouverture (110) communiquant avec la première chambre de ventilation (141) ; et
le deuxième canal (150) communiquant avec la première chambre de ventilation (141) pour mettre en communication le baromètre (300) avec la première ouverture (110);
la première chambre de ventilation (141) étant une chambre en forme de bande s'étendant le long d'une première direction, le premier sous-canal (142) étant un canal en forme de bande situé dans un premier plan, et la première direction étant définie selon un angle par rapport au premier plan ;
le premier canal (140) et le deuxième canal (150) étant indépendants l'un de l'autre.

2. Dispositif électronique selon la revendication 1, dans lequel le deuxième canal (150) comprend une deuxième chambre de ventilation (151) et un deuxième sous-canal (152), et le baromètre (300) communique avec la deuxième chambre de ventilation (151) par l'intermédiaire du deuxième sous-canal (152) ; et
le boîtier (100) est pourvu intérieurement d'une première plaque de séparation (160) située entre la première chambre de ventilation (141) et la deuxième chambre de ventilation (151), la première plaque de séparation (160) étant pourvue d'un trou d'aération, et la première chambre de ventilation (141) étant mise en communication avec la deuxième chambre de ventilation (151) par l'intermédiaire du trou d'aération.

3. Dispositif électronique selon la revendication 2, dans lequel
la première chambre de ventilation (141) comprend une première extrémité ouverte et une première extrémité fermée, la première extrémité ouverte étant opposée à la première extrémité fermée, la première chambre de ventilation (141) étant mise en communication avec une première extrémité du premier sous-canal (142) par l'intermédiaire de la première extrémité ouverte, et un la seconde extrémité du premier sous-canal (142) est orientée vers le premier module acoustique (200) ; et
une distance entre l'orifice d'évent et la première extrémité fermée est inférieure à une distance entre l'orifice d'évent et la première extrémité ouverte.

4. Dispositif électronique selon la revendication 1, dans lequel la première ouverture (110) est un orifice traversant s'étendant depuis une paroi externe du boîtier (100) jusqu'à une paroi interne de la première chambre de ventilation (141).

5. Dispositif électronique selon la revendication 1, dans lequel le boîtier (100) est en outre pourvu d'une deuxième ouverture (190), le boîtier (100) est en outre pourvu d'un troisième canal (170), et le troisième canal (170) met le baromètre (300) en communication avec la deuxième ouverture (190).

6. Dispositif électronique selon la revendication 5, dans lequel le dispositif électronique comprend en outre un deuxième module acoustique (400), le deuxième module acoustique (400) est disposé dans le boîtier (100), le boîtier (100) est en outre pourvu d'un quatrième canal (180), et le quatrième canal (180) met le deuxième module acoustique (400) en communication avec la deuxième ouverture (190).

7. Dispositif électronique selon la revendication 6, dans lequel la deuxième ouverture (190) est une fente en forme de bande formée dans le boîtier (100), une deuxième plaque de séparation (192) est disposée dans la fente en forme de bande, la deuxième plaque de séparation (192) divise la fente en forme de bande en une première sous-fente (191) et une deuxième sous-fente (193), le troisième canal (170) met le baromètre (300) en communication avec la première sous-fente (191), et le quatrième canal (180) met le deuxième module acoustique (400) en communication avec la deuxième sous-fente (193).

8. Dispositif électronique selon la revendication 7, dans lequel une aire d'ouverture de la première sous-fente (191) est inférieure à une aire d'ouverture de la deuxième sous-fente (193).

9. Dispositif électronique selon la revendication 7, dans lequel la fente en forme de bande comprend un premier segment, un deuxième segment (1931) et un troisième segment (1932), le deuxième segment (1931) est situé entre le premier segment et le troisième segment (1932), le premier segment forme la première sous-fente (191), le deuxième segment (1931) et le troisième segment (1932) forment la deuxième sous-fente (193), et le quatrième canal (180) met le deuxième module acoustique en communication avec le troisième segment (1932).
